# EUROPÄISCHE PATENTANMELDUNG

(11) **EP 3 993 171 A1**
(43) Veröffentlichungstag der Anmeldung: **04.05.2022**
(21) Anmeldenummer: 21204972.0
(22) Anmeldetag: 27.10.2021
(51) Int. Cl.: H01R 13/443, H01R 13/66, H01R 13/717, H01R 24/64, H01R 107/00

(54) **BLINDSTECKER, DATENÜBERTRAGUNGSSYSTEM UND VERFAHREN ZUR ANZEIGE EINER STROMVERSORGUNGSKAPAZITÄT**

(30) Priorität: 29.10.2020 DE 102020128513
(71) Anmelder: Reichle & De-Massari AG, 8620 Wetzikon (CH)
(72) Erfinder: Gerber, Matthias, 8630 Rüti ZH (CH); Gerber, Nikolas, 8630 Rüti ZH (CH); Kupec, Jan, 8620 Sunnehalde 2 (CH)
(74) Vertreter: Daub, Thomas

(57) **Zusammenfassung**

Die Erfindung geht aus von einem Blindstecker (12a-b), insbesondere RJ45-Blindstecker, mit zumindest einer Datensteckereinheit (14a-b), welche zu einer Verbindung mit einer Gegendatensteckereinheit (16a), insbesondere einer RJ45-Steckerbuchse, vorgesehen ist.

Um eine gattungsgemäße Vorrichtung mit verbesserten Eigenschaften hinsichtlich einer Effizienz bereitzustellen, wird vorgeschlagen, dass die Datensteckereinheit (14a-b) eine Ausgabeeinheit (18a) aufweist, welche dazu vorgesehen ist, eine Stromversorgungskapazität der Gegendatensteckereinheit (16a) anzuzeigen.

## Beschreibung

### Stand der Technik

Die Erfindung betrifft einen Blindstecker nach dem Oberbegriff des Anspruchs 1, ein Datenübertragungssystem nach Anspruch 16 und ein Verfahren zur Anzeige einer Stromversorgungskapazität nach Anspruch 17.

Aus dem Stand der Technik ist bereits ein Datenübertragungssystem, insbesondere ein RJ45-System, bekannt, welches dazu vorgesehen ist, eine Power over Ethernet (PoE) Verbindung bereitzustellen. Zudem ist bereits eine Datensteckereinheit des Datenübertragungssystems bekannt, welche mit einer Gegendatensteckereinheit des Datenübertragungssystems, insbesondere einer RJ45-Steckerbuchse, verbindbar ist, wobei für eine PoE Verbindung die Gegendatensteckereinheit einen PoE Anschluss definiert. Mittels eines Prüfsteckers des Datenübertragungssystems ist überprüfbar, ob an der Gegendatensteckereinheit eine elektrische Spannung anliegt und es sich um den PoE Anschluss handelt. Der Prüfstecker ist zu der Überprüfung der elektrischen Spannung mit der Gegendatensteckereinheit verbindbar, wobei der Prüfstecker nach der Überprüfung wieder von der Gegendatensteckereinheit getrennt wird.

Des Weiteren ist aus dem Stand der Technik ebenfalls ein Blindstecker, insbesondere ein RJ45-Blindstecker, bekannt, welcher zu einem Staubschutz in die Gegendatensteckereinheit einsteckbar ist.

Die Aufgabe der Erfindung besteht insbesondere darin, eine gattungsgemäße Vorrichtung mit verbesserten Eigenschaften hinsichtlich einer Effizienz bereitzustellen. Die Aufgabe wird erfindungsgemäß durch die Merkmale des Anspruchs 1, 16 und 17 gelöst, während vorteilhafte Ausgestaltungen und Weiterbildungen der Erfindung den Unteransprüchen entnommen werden können.

### Vorteile der Erfindung

Die Erfindung geht aus von einem Blindstecker, insbesondere einem RJ45-Blindstecker, mit zumindest einer Datensteckereinheit, welche zu einer Verbindung mit einer Gegendatensteckereinheit, insbesondere einer RJ45-Steckerbuchse, vorgesehen ist.

Es wird vorgeschlagen, dass die Datensteckereinheit eine Ausgabeeinheit aufweist, welche dazu vorgesehen ist, eine Stromversorgungskapazität der Gegendatensteckereinheit anzuzeigen.

Durch eine derartige Ausgestaltung kann eine hohe Effizienz, und zwar insbesondere in Bezug auf eine Arbeits- und/oder Kosteneffizienz, erreicht werden. Mittels der Ausgabeeinheit kann festgestellt werden, ob es sich bei der Gegendatensteckereinheit um einen klassischen Ethernet Anschluss oder einen Power over Ethernet (PoE) Anschluss handelt. Somit kann die Stromversorgungskapazität von Ethernet-Systemen getestet werden. Zudem kann mittels des Blindsteckers die Gegendatensteckereinheit, insbesondere die Elektronik der Gegendatensteckereinheit, vor Staub und/oder äußeren Einflüssen geschützt werden. Folglich kann aufgrund der Multifunktionalität des Blindsteckers auf zusätzliche Geräte, insbesondere Prüfstecker und/oder separate Staubschutze, verzichtet werden. Des Weiteren kann mittels eines Abfrageimpulses des Datenübertragungssystems das Datenübertragungssystem den verbundenen Blindstecker erkennen und eine Ansteuerung des Blindsteckers an den Blindstecker anpassen und/oder steuern und/oder regeln.

Das Datenübertragungssystem, insbesondere das RJ45-System, könnte beispielsweise zumindest ein Netzwerk, insbesondere Local Area Network (LAN), vorzugsweise Ethernet-Netzwerk, aufweisen. Das Datenübertragungssystem ist dazu vorgesehen, zumindest eine Datenverbindung, insbesondere Ethernet-Verbindung, zu einer Übertragung von Daten zwischen zumindest einem Power Sourcing Equipment (PSE) des Datenübertragungssystems und einer Empfangseinheit des Datenübertragungssystems bereitzustellen. Die Empfangseinheit könnte beispielsweise ein Power Device (PD) oder auch ein erfindungsgemäßer Blindstecker, insbesondere ein RJ45-Blindstecker, sein. Das PSE könnte beispielsweise ein Router und/oder ein Hub und/oder vorteilhaft ein Switch sein. Vorzugsweise ist das Datenübertragungssystem dazu befähigt, neben der Datenverbindung auch eine Stromversorgung für die Empfangseinheit bereitzustellen. Eine von dem Datenübertragungssystem bereitgestellte sogenannte Power over Ethernet (PoE) Verbindung ist insbesondere dazu ausgelegt, das Datensignal, insbesondere ein LAN-Signal, und eine Stromversorgung gleichzeitig an die Empfangseinheit zu übertragen. Es wäre denkbar, dass das PD beispielsweise eine statische Überwachungskamera und/oder ein VolP-Telefon und/oder ein IP-Telefon und/oder ein Computer und/oder ein Flachbildschirm und/oder ein Alarmsystem ist.

Vorzugsweise weist das Datenübertragungssystem die Gegendatensteckereinheit, insbesondere RJ45-Steckerbuche, zu einer Verbindung zwischen der Empfangseinheit und der PSE auf. Die Gegendatensteckereinheit umfasst zumindest zwei Gegenkontakte, vorzugsweise acht Gegenkontakte. Die Gegenkontakte könnten beispielsweise zumindest teilweise und/oder zu einem Großteil aus einem Metall, insbesondere Kupfer oder Gold und/oder anderem elektrisch leitenden Material und/oder einem Verbundmaterial bestehen. Unter dem Ausdruck "zu einem Großteil" sollen dabei beispielsweise zumindest 55 %, vorteilhaft zumindest 65 %, vorzugsweise zumindest 75 %, besonders bevorzugt zumindest 85 % und besonders vorteilhaft höchstens 95 % eines Volumen- und/oder Massenanteils verstanden werden.

Insbesondere bilden die Gegenkontakte jeweils Paare, insbesondere bilden die Gegenkontakte vier Paare. Zu einer Übertragung des Datensignals und/oder der Stromversorgung sind insbesondere zumindest zwei der Paare der Gegenkontakte vorgesehen. Beispielsweise könnten genau zwei der Paare der Gegenkontakte das Datensignal und/oder die Stromversorgung übertragen. Insbesondere bezeichnet eine PoE Verbindung über zwei der Paare der Gegenkontakte eine PoE Typ-1 Verbindung, insbesondere gemäß dem IEEE 802.3af Standard. Es wäre jedoch auch denkbar, dass eine PoE Typ-2 Verbindung, insbesondere gemäß dem IEEE 802.3at Standard, über zwei der Paare der Gegenkontakte herstellbar ist. Alternativ könnten vier der Paare der Gegenkontakte das Datensignal und/oder die Stromversorgung übertragen. Insbesondere ist eine PoE Verbindung, welche über vier der Paare der Gegenkontakte verläuft, eine PoE Typ-3 Verbindung oder eine PoE Typ-4 Verbindung, insbesondere gemäß dem IEEE 802.3bt (Typ 3) Standard oder gemäß dem IEEE 802.3bt (Typ 4) Standard. Das Datensignal und die Stromversorgung könnten beispielsweise über zwei verschiedene Paare der Paare der Gegenkontakte übertragbar sein. Alternativ könnte das Paar der Gegenkontakte, welches das Datensignal überträgt, identisch zu dem Paar der Gegenkontakte sein, welches die Stromversorgung überträgt. Es wäre jedoch auch denkbar, dass das Datensignal über vier der Paare der Gegenkontakte übertragbar und die Stromversorgung von zwei dieser vier Paare der Gegenkontakte bereitstellbar ist. Vorzugsweise ist bei einer möglichen PoE Verbindung die Stromversorgungskapazität der Gegendatensteckereinheit, insbesondere an zumindest zwei der Paare der Gegenkontakte, messbar und/oder anzeigbar. Insbesondere zeigt der Blindstecker die Stromversorgungskapazität von zumindest zwei der Paare der Gegenkontakte an. Vorzugsweise könnte der Blindstecker dazu ausgelegt sein, eine PoE Typ Verbindung anzuzeigen. Alternativ und/oder zusätzlich könnte mittels des Blindsteckers anzeigbar sein, über welche der Paare der Gegenkontakte die PoE Verbindung, insbesondere die PoE Typ Verbindung, verläuft.

In zumindest einem Betriebszustand könnte das Datensignal und/oder die Stromversorgung zwischen der Gegendatensteckereinheit und der Empfangseinheit übertragbar sein. Vorzugsweise ist in einem montierten Zustand der Blindstecker mit der Gegendatensteckereinheit verbunden, sodass in dem Betriebszustand der Blindstecker die Stromversorgungskapazität der Gegendatensteckereinheit für die PoE Verbindung überprüft und anzeigt. Insbesondere überprüft und/oder erkennet das PSE, ob zumindest das PD oder der Blindstecker mit der Gegendatensteckereinheit verbunden ist. Ist das PD mit der Gegendatensteckereinheit verbunden, könnte das PSE die Übertragung des Datensignals und der Stromversorgung, insbesondere einer PoE Spannung, ermöglichen und/oder regeln. Insbesondere könnte das PSE erkennen, ob der Blindstecker in dem montierten Zustand mit der Gegendatensteckereinheit verbunden ist.

Zu einer Überprüfung, ob eine PoE Verbindung mit der Empfangseinheit aufbaubar ist, insbesondere ob ein PD mit der Gegendatensteckereinheit verbunden ist, könnte das Datenübertragungssystem zumindest einen oder mehrere verschiedene Tests durchführen. Beispielsweise simuliert das PSE das PD. Alternativ und vorzugsweise könnte das PSE mittels eines Detektionssignals die Empfangseinheit detektieren. Insbesondere enthält das Detektionssignal zumindest einen Abfrageimpuls, insbesondere mehrere einzelne Abfrageimpulse. Das PSE könnte zumindest den Anfrageimpuls an die Empfangseinheit senden. Insbesondere ist der Abfrageimpuls standardisiert. Der Abfrageimpuls könnte beispielsweise eine Testspannung von zumindest 2,8 V, vorteilhaft zumindest 10 V und besonders bevorzugt höchstens 30 V, sowie beispielsweise eine Abfragedauer von beispielsweise zumindest 0,1 s, vorteilhaft zumindest 0,2 s und besonders bevorzugt höchstens 0,5 s aufweisen. Insbesondere weist der Abfrageimpuls einen Kurzschlussstrom von beispielsweise höchstens 2 mA, vorzugsweise höchstens 3 mA und besonders bevorzugt höchstens 5 mA auf. Es wäre denkbar, dass das PSE den Test, insbesondere den Abfrageimpuls, beispielsweise in einem Rhythmus von insbesondere 5 s, vorzugsweise 3 s und besonders bevorzugt von 2 s wiederholt, bis das PSE ein verbundenes PD erkennt.

Bei zumindest einem der Tests könnte das PSE das verbundene PD erkennen, wenn zumindest eine Last von insbesondere zumindest 19 kOhm, vorzugsweise zumindest 23 kOhm und vorteilhaft höchstens 26.5 kOhm detektierbar ist. Insbesondere ist eine Kapazität des verbundenen PD auf beispielsweise zumindest 100 nF, vorzugsweise zumindest 120 nF, und besonders bevorzugt auf 150 nF begrenzt. Alternativ könnte das PSE die detektierte Empfangseinheit als das verbundene PD ablehnen, wenn die Last insbesondere kleiner ist als 15 kOhm oder vorzugsweise zumindest 33 kOhm überschreitet.

In dem montierten Zustand und in zumindest dem Betriebszustand überprüft das PSE die mit der Gegendatensteckereinheit verbundene Empfangseinheit. Insbesondere erkennt das PSE den Blindstecker. Vorzugsweise ist der Blindstecker in dem montierten Zustand und in dem Betriebszustand über die Datensteckereinheit mit der Gegendatensteckereinheit verbunden und dazu fähig, die Stromkapazitätsversorgung der Gegendatensteckereinheit, insbesondere der PSE, mittels der Ausgabeeinheit anzuzeigen.

In zumindest dem Betriebszustand befindet sich die Ausgabeeinheit zu einer optischen und/oder akustischen Ausgabe, insbesondere Anzeige, für einen Bediener in zumindest einem Ausgabezustand. In dem Ausgabezustand könnte die Ausgabeeinheit dem Bediener optisch, beispielsweise durch ein Leuchtsignal, und/oder akustisch, beispielsweise durch einen Signalton, die vorliegende Stromversorgungskapazität der Gegendatensteckereinheit optisch und/oder akustisch anzeigen. Alternativ und/oder zusätzlich könnte die Ausgabeeinheit in dem Ausgabezustand ein Signal, beispielsweise ein Funksignal, an ein externes Gerät, beispielsweise ein mobiles Endgerät, insbesondere ein Smartphone, senden und/oder übertragen.

Vorzugsweise stellt der Blindstecker in dem montierten Zustand und insbesondere in zumindest dem Betriebszustand einen Staubschutz für die Gegendatensteckereinheit bereit.

Unter "vorgesehen" soll speziell programmiert, ausgelegt und/oder ausgestattet verstanden werden. Darunter, dass ein Objekt zu einer bestimmten Funktion vorgesehen ist, soll verstanden werden, dass das Objekt diese bestimmte Funktion in zumindest einem Anwendungs- und/oder Betriebszustand erfüllt und/oder ausführt.

Ferner wird vorgeschlagen, dass in zumindest einem Betriebszustand, insbesondere in zumindest dem Betriebszustand, zumindest eine elektrische Kenngröße der Ausgabeeinheit unterhalb oder oberhalb eines Grenzwerts der elektrischen Kenngröße für eine Detektion als Power Device (PD) liegt. Dadurch kann eine Effizienz weiter gesteigert werden, da das PSE lediglich nur dann eine PoE Verbindung mit einem PD herstellt und das PD mit einem Datensignal und einer PoE Spannung versorgt, wenn das PSE das PD detektiert. Da bei leistungslimitierten PSEs eine Anzahl an Gegendatensteckereinheiten, über welche die PoE Verbindung aufbaubar ist, limitiert ist, kann mittels des Abfrageimpulses der verbundene Blindstecker erkannt werden. Dadurch kann das PSE lediglich diejenige Gegendatensteckereinheit mit dem Datensignal und der PoE Spannung ansteuern, welche mit dem PD verbunden ist und damit eine Effizienz hinsichtlich einer Ansteuerung der Empfangseinheit weiter optimiert werden.

Insbesondere handelt es sich bei der elektrischen Kenngröße um die zuvor genannte Last. Vorzugsweise könnte das PSE den Blindstecker erkennen, wenn die elektrische Kenngröße, insbesondere die Last, vorteilhaft kleiner als 15 kOhm ist. In zumindest dem montierten Zustand und in zumindest dem Betriebszustand könnte das PSE lediglich die Stromversorgung für den Blindstecker bereitstellen. Vorzugsweise betreibt die PSE den Blindstecker, insbesondere die Ausgabeeinheit, mit dem Detektionssignal, insbesondere der Testspannung des Abfrageimpulses.

Es wäre denkbar, dass die Ausgabeeinheit ein elektronisches Papier (e-paper, ePaper) umfasst. Vorteilhaft weist die Ausgabeeinheit zumindest ein Leuchtmittel, insbesondere eine LED, auf. Dadurch kann eine Effizienz hinsichtlich einer energieeffizienten und kompakten Konstruktion der Ausgabeeinheit ermöglicht werden. Zudem kann aufgrund einer Strombegrenzung des Datenübertragungssystems, insbesondere der PSE, das Leuchtmittel direkt, insbesondere mittels eines direkten elektrischen Kontakts, mit der Gegendatensteckereinheit verbunden werden, sodass die Ausgabeeinheit frei von zumindest einem Vorwiderstand ist.

Das Leuchtmittel könnte beispielsweise eine grüne oder blaue LED sein. Vorzugsweise ist die LED orangerot oder rot. Besonders bevorzugt könnte das von dem Leuchtmittel emittierte Licht eine Wellenlänge von insbesondere zumindest 600 nm, vorzugsweise zumindest 625 nm und vorteilhaft von höchstens 640 nm aufweisen. Insbesondere handelt es sich bei dem Leuchtmittel um eine Low Current LED. Die als Low Current LED ausgebildete LED könnte bei der Stromversorgung von insbesondere zumindest 5 mA, vorteilhaft zumindest 2 mA und besonders bevorzugt bereits bei zumindest 1 mA in zumindest dem Betriebszustand leuchten. Es wäre denkbar, dass die LED den Abfrageimpuls direkt anzeigt. Hierbei könnte die LED in zumindest dem Ausgabezustand blinken. Beispielsweise könnte die LED in dem Anzeigezustand zumindest für beispielsweise 0,5 s Licht emittieren und für beispielsweise zumindest 1,5 s ausgeschaltet sein. Alternativ könnte die LED in einem Ausgabezustand dauerhaft leuchten, insbesondere leuchtet die LED dauerhaft, wenn in zumindest dem Betriebszustand das PSE das PD simuliert. In einem weiteren Ausgabezustand der Ausgabeeinheit könnte die LED vollständig ausgeschaltet sein.

Ferner wird vorgeschlagen, dass die Datensteckereinheit zumindest eine Leiterplatte aufweist, welche Kontakte zur Kontaktierung mit Gegenkontakten der Gegendatensteckereinheit aufweist. Dadurch kann eine energieeffiziente und präzise elektrische Kontaktierung zwischen der Datensteckereinheit, insbesondere der LED, und der Gegendatensteckereinheit ermöglicht werden.

Die Leiterplatte weist zumindest eine Ober- und eine Unterseite auf. Beispielsweise könnten die Kontakte auf der Oberseite oder der Unterseite der Leiterplatte angeordnet sein. Vorzugsweise erstrecken sich die Kontakte über eine der Gegendatensteckereinheit zugewandte Seite der Leiterplatte, insbesondere einer Stirnseite der Leiterplatte. Die der Gegendatensteckereinheit zugewandte Seite der Leiterplatte erstreckt sich zumindest im Wesentlichen senkrecht zu der Oberseite und der Unterseite. Die Kontakte könnten beispielsweise zumindest teilweise und/oder zu einem Großteil aus einem Metall, insbesondere Kupfer oder Gold und/oder anderem elektrisch leitenden Material und/oder einem Verbundmaterial bestehen. Insbesondere könnten die Kontakte von einer Anzahl her an eine Anzahl der Gegenkontakte angepasst sein. Vorzugsweise könnte die Leiterplatte acht Kontakte aufweisen. Die Kontakte könnten jeweils Paare bilden, welche mit den Paaren der Gegenkontakte verbindbar sind. Insbesondere weist die Leiterplatte vier Paare der Kontakte auf. Vorteilhaft überträgt sich das Datensignal und/oder die Stromversorgung über die Kontakte und die Gegenkontakte, insbesondere über jeweils zwei verbundene Paare der Kontakte und Gegenkontakte. Beispielsweise könnten in zumindest dem Betriebszustand zwei der Paare der Kontakte das Datensignal und/oder die Stromversorgung zwischen der Empfangseinheit und den Gegenkontakten übertragen. Es wäre jedoch auch denkbar, dass in zumindest dem Betriebszustand vier der Paare der Kontakte das Datensignal und zwei der Paare der Kontakte, insbesondere zwei zu den vier identischen Paaren der Kontakte, die Stromversorgung bereitstellen. Alternativ könnten vier der Paare der Kontakte das Datensignal und die Stromversorgung übertragen.

In einer weiteren Ausgestaltung der Erfindung wird vorgeschlagen, dass die Leiterplatte zumindest einen ersten Leitungspfad, welcher einen ersten der Kontakte mit einem ersten Anschluss des Leuchtmittels elektrisch leitend verbindet, und zumindest einen zweiten Leitungspfad, welcher einen zweiten der Kontakte mit einem zweiten Anschluss des Leuchtmittels elektrisch leitend verbindet, aufweist, über welche das Leuchtmittel mit zumindest zwei der Kontakte elektrisch leitend verbunden ist. Damit kann eine Effizienz hinsichtlich einer elektrischen Kontaktsicherheit zwischen der Datensteckereinheit, insbesondere der LED, und der Gegendatensteckereinheit weiter gesteigert werden. Zudem kann mittels des ersten Leitungspfads und des zweiten Leitungspfads explizit festgestellt werden, ob eine Stromversorgung über zumindest den ersten der Kontakte und zumindest den zweiten der Kontakte möglich ist.

Das Leuchtmittel könnte an der Unterseite der Leiterplatte angeordnet sein. Vorzugsweise ist das Leuchtmittel mit zumindest zwei Paaren der Kontakte, insbesondere vier Kontakten, verbunden. Es wäre denkbar, dass der erste der Kontakte mit einem zusätzlichen ersten Kontakt der Kontakte, insbesondere einem benachbarten Kontakt des ersten Kontakts, ein erstes Paar der Kontakte bildet. Der erste Leitungspfad könnte zumindest einen ersten Leitungspfadabschnitt aufweisen, welcher mit dem ersten der Kontakte verbunden ist. Zusätzlich könnte der erste Leitungspfad einen zusätzlichen ersten Leitungspfadabschnitt, insbesondere einen dem ersten Leitungspfadabschnitt benachbarten Leitungspfadabschnitt, aufweisen, welcher mit dem zusätzlichen ersten Kontakt verbunden ist. Vorteilhaft sind der erste Leitungspfadabschnitt und der zusätzliche erste Leitungspfadabschnitt zumindest teilweise einstückig ausgebildet, insbesondere miteinander kurzgeschlossen. Der erste Leitungspfad könnte über den ersten Leitungspfadabschnitt und den zusätzlichen ersten Leitungspfadabschnitt den ersten Anschluss des Leuchtmittels mit dem ersten Paar der Kontakte, insbesondere dem ersten Kontakt und dem zusätzlichen ersten Kontakt, verbinden. Alternativ und/oder zusätzlich könnte der zweite der Kontakte mit einem zusätzlichen zweiten der Kontakte ein zweites Paar der Kontakte bilden. Der zweite Leitungspfad könnte zumindest einen zweiten Leitungspfadabschnitt aufweisen, welcher mit dem zweiten der Kontakte verbunden ist. Zusätzlich könnte der zweite Leitungspfad einen zu dem zweiten Leitungspfadabschnitt zusätzlichen zweiten Leitungspfadabschnitt aufweisen, welcher mit dem zusätzlichen zweiten Kontakt verbunden ist. Vorteilhaft sind der zweite Leitungspfadabschnitt und der zusätzliche zweite Leitungspfadabschnitt zumindest teilweise einstückig verbunden, insbesondere miteinander kurzgeschlossen. Der zweite Leitungspfad könnte über den zweiten Leitungspfadabschnitt und den zusätzlichen zweiten Leitungspfadabschnitt den zweiten Anschluss des Leuchtmittels mit dem zweiten Paar der Kontakte, insbesondere dem zweiten Kontakt und zusätzlichen zweiten Kontakt, verbinden.

Es wäre denkbar, dass der erste Leitungspfad, insbesondere der erste Kontakt und der zusätzliche erste Kontakt, eine positive Spannung und der zweite Leitungspfad, insbesondere der zweite Kontakt und der zusätzliche zweite Kontakt, eine negative Spannung aufweist. Vorzugsweise könnte der erste Leitungspfad, insbesondere der erste Kontakt und der zusätzliche erste Kontakt, eine negative Spannung und der zweite Leitungspfad, insbesondere der zweite Kontakt und der zusätzliche zweite Kontakt, eine positive Spannung aufweisen.

Um eine Effizienz hinsichtlich einer Flexibilität weiter zu steigern, wird vorgeschlagen, dass die Ausgabeeinheit ein weiteres Leuchtmittel, insbesondere eine weitere LED, und die Leiterplatte zumindest einen weiteren ersten Leitungspfad, welcher einen weiteren ersten der Kontakte mit einem weiteren ersten Anschluss des weiteren Leuchtmittels elektrisch leitend verbindet, und zumindest einen weiteren zweiten Leitungspfad, welcher einen weiteren zweiten der Kontakte mit einem weiteren zweiten Anschluss des weiteren Leuchtmittels elektrisch leitend verbindet, aufweist, über welche das weitere Leuchtmittel mit zumindest weiteren zwei der Kontakte elektrisch leitend verbunden ist. Damit kann eine Effizienz hinsichtlich einer Flexibilität erhöht werden, da mittels des Leuchtmittels und des weiteren Leuchtmittels alle vier Kontaktpaare der Kontakte, insbesondere alle acht Kontakte, mit den Gegenkontakten, insbesondere den acht Gegenkontakten, verbunden sind und unabhängig von einer Ansteuerung durch das PSE die Stromversorgungskapazität der Gegendatensteckereinheit anzeigt werden kann. Zudem kann mittels des Leuchtmittels und des weiteren Leuchtmittels eine Klassifizierung der PoE Typ-Verbindung, insbesondere ein IEEE Standard, ermöglicht werden. Des Weiteren kann festgestellt werden, über welche der Kontakte, insbesondere welche Paare der Kontakte, eine PoE Verbindung mit der PSE besteht.

Das weitere Leuchtmittel, insbesondere die weitere LED, könnte zu der dem Leuchtmittel, insbesondere der LED, identisch sein. Alternativ könnte das weitere Leuchtmittel zumindest eine von dem Leuchtmittel verschiedene technische Funktion aufweisen. Insbesondere könnte die weitere LED eine von der LED verschiedene Farbe aufweisen. An der Unterseite der Leiterplatte könnte das weitere Leuchtmittel angeordnet sein. Vorzugsweise ist das weitere Leuchtmittel mit zumindest weiteren zwei Paaren der Kontakte, insbesondere weiteren vier Kontakten, verbunden. Die weiteren zwei Paare der Kontakte sind insbesondere verschieden zu den zwei Paaren der Kontakte, mit welchen das Leuchtmittel verbunden ist. Es wäre denkbar, dass der weitere erste der Kontakte mit einem weiteren zusätzlichen ersten Kontakt der Kontakte, insbesondere einem weiteren benachbarten Kontakt des weiteren ersten Kontakts, ein weiteres erstes Paar der Kontakte bildet. Der weitere erste Leitungspfad könnte zumindest einen weiteren ersten Leitungspfadabschnitt aufweisen, welcher mit dem weiteren ersten der Kontakte verbunden ist. Zusätzlich könnte der weitere erste Leitungspfad einen weiteren zusätzlichen ersten Leitungspfadabschnitt, insbesondere einen dem weiteren ersten Leitungspfadabschnitt benachbarten weiteren Leitungspfadabschnitt, aufweisen, welcher mit dem weiteren zusätzlichen ersten Kontakt verbunden ist. Vorteilhaft sind der weitere erste Leitungspfadabschnitt und der weitere zusätzliche erste Leitungspfadabschnitt zumindest teilweise einstückig ausgebildet, insbesondere miteinander kurzgeschlossen. Der weitere erste Leitungspfad könnte über den weiteren ersten Leitungspfadabschnitt und den weiteren zusätzlichen ersten Leitungspfadabschnitt den weiteren ersten Anschluss des weiteren Leuchtmittels mit dem weiteren ersten Paar der Kontakte, insbesondere dem weiteren ersten Kontakt und dem weiteren zusätzlichen ersten Kontakt verbinden. Alternativ und/oder zusätzlich könnte der weitere zweite der Kontakte mit einem weiteren zusätzlichen zweiten der Kontakte ein weiteres zweites Paar der Kontakte bilden. Der weitere zweite Leitungspfad könnte zumindest einen weiteren zweiten Leitungspfadabschnitt aufweisen, welcher mit dem weiteren zweiten der Kontakte verbunden ist. Zusätzlich könnte der weitere zweite Leitungspfad einen zu dem weiteren zweiten Leitungspfadabschnitt weiteren zusätzlichen zweiten Leitungspfadabschnitt aufweisen, welcher mit dem weiteren zusätzlichen zweiten Kontakt verbunden ist. Vorteilhaft sind der weitere zweite Leitungspfadabschnitt und der weitere zusätzliche zweite Leitungspfadabschnitt teilweise zumindest einstückig verbunden, insbesondere miteinander kurzgeschlossen. Der weitere zweite Leitungspfad könnte über den weiteren zweiten Leitungspfadabschnitt und den weiteren zusätzlichen zweiten Leitungspfadabschnitt den weiteren zweiten Anschluss des weiteren Leuchtmittels mit dem weiteren zweiten Paar der Kontakte, insbesondere dem weiteren zweiten Kontakt und dem weiteren zusätzlichen zweiten Kontakt, verbinden. Der weitere erste Kontakt könnte mit dem weiteren zusätzlichen ersten Kontakt benachbart sein. Alternativ und/oder zusätzlich könnte der weitere zweite Kontakt mit dem weiteren zweiten Kontakt benachbart sein.

Es wäre denkbar, dass der weitere erste Leitungspfad, insbesondere der weitere erste Kontakt und der weitere zusätzliche erste Kontakt, eine positive Spannung und der weitere zweite Leitungspfad, insbesondere der weitere zweite Kontakt und der weitere zusätzliche zweite Kontakt, eine negative Spannung aufweist. Vorzugsweise könnte der weitere erste Leitungspfad, insbesondere der weitere erste Kontakt und der weitere zusätzliche erste Kontakt, eine negative Spannung und der weitere zweite Leitungspfad, insbesondere der weitere zweite Kontakt und der weitere zusätzliche zweite Kontakt, eine positive Spannung aufweisen.

In zumindest dem Betriebszustand könnten das Leuchtmittel und/oder das weitere Leuchtmittel einen Typ der PoE Verbindung, insbesondere einen IEEE Standard, anzeigen. Insbesondere könnte die LED oder die weitere LED in zumindest dem Betriebszustand leuchten, wenn die PoE Typ-1, insbesondere der IEEE 802.3af Standard, oder die PoE Typ-2 Verbindung, insbesondere der IEEE 802.3at Standard, vorliegt. Alternativ könnten die LED und die weitere LED in zumindest dem Betriebszustand gemeinsam leuchten und damit die PoE Typ-3 oder die PoE Typ-4 Verbindung, insbesondere den IEEE 802.3bt (Typ 3) oder den IEEE 802.3bt (Typ 4) Standard, anzeigen.

Zudem wird vorgeschlagen, dass der erste und/oder der zweite Leitungspfad über eine Kante der Leiterplatte verläuft. Alternativ und/oder zusätzlich könnten der weitere erste Leitungspfad und/oder der weitere zweite Leitungspfad über die Kante der Leiterplatte verlaufen. Dadurch kann eine Effizienz hinsichtlich einer elektrischen Kontaktierung zwischen der Datensteckereinheit und der Gegendatensteckereinheit weiter gesteigert werden. Zudem kann eine optimierte, kompakte und besonders dünne Ausgestaltung der Leiterplatte ermöglicht werden. Zudem kann eine Kosteneffizienz, insbesondere bei einer Herstellung der Leiterplatte, und bei einer gleichbleibenden Kontaktsicherheit mit der Gegendatensteckereinheit bereitgestellt werden. Des Weiteren kann bei zumindest einem Verfahrensschritt bei der Herstellung der Leiterplatte eine Maske auf die Oberseite der Leiterplatte aufgetragen werden, welche die Leitungspfade schützt. Damit kann bei zumindest dem Verfahrensschritt bei der Herstellung der Leiterplatte auf eine Bearbeitung mit einem Lötstopplack verzichtet werden.

Die Kante könnte sich an der der Gegendatensteckereinheit zugewandten Seite der Leiterplatte, insbesondere der Stirnseite der Leiterplatte, befinden. Beispielsweise könnte die Kante Einbuchtungen aufweisen. Insbesondere entspricht eine Anzahl an Einbuchtungen der Anzahl an Kontakten, vorzugsweise einer RJ45-Norm. Vorzugsweise verbindet der Leitungspfad und/oder der zweite Leitungspfad, die Oberseite der Leiterplatte elektrisch mit der Unterseite der Leiterplatte. Insbesondere könnte auf der Oberseite der Leiterplatte der erste Leitungspfadabschnitt und der zusätzliche erste Leitungspfadabschnitt, insbesondere alternativ und/oder zusätzlich der weitere erste Leitungspfadabschnitt und der weitere zusätzliche erste Leitungspfadabschnitt, angeordnet und zumindest teilweise einstückig ausgebildet sein. Zusätzlich könnten der zweite Leitungspfadabschnitt und der zusätzliche zweite Leitungspfadabschnitt, insbesondere alternativ und/oder zusätzlich der weitere zweite Leitungspfadabschnitt und der weitere zusätzliche zweite Leitungspfadabschnitt, auf der Oberseite der Leiterplatte angeordnet und zumindest teilweise einstückig ausgebildet sein. Auf der Unterseite der Leiterplatte könnten sich der erste Anschluss und/oder der zweite Anschluss, insbesondere und/oder der weitere erste Anschluss und/oder der weitere zweite Anschluss, befinden. Der erste Leitungspfad und/oder der zweite Leitungspfad könnten beispielsweise zumindest teilweise und/oder zu einem Großteil aus einem Metall, insbesondere Kupfer oder Gold und/oder anderem elektrisch leitenden Material und/oder einem Verbundmaterial bestehen. In zumindest einem Verfahrensschritt zur Herstellung der Leiterplatte könnte die für den ersten und/oder den zweiten Leitungspfad zu metallisierende Kante vor zumindest einem Durchkontaktierungsprozess gefräst und/oder ausgestanzt und/oder gelasert werden. Es wäre auch denkbar, dass in dem Verfahrensschritt zur Herstellung der Leiterplatte, insbesondere den Einbuchtungen, die Leiterplatte über zumindest 20 %, vorzugsweise zumindest 30 % und besonders bevorzugt zumindest 50 % eines Durchmessers der Leiterplatte angefräst wird. In zumindest einem weiteren Verfahrensschritt zur Herstellung der Leiterplatte, insbesondere einem Durchkontaktieren, könnte die Kante, insbesondere die Einbuchtungen, metallisiert werden.

Die Oberseite könnte eine Maske aufweisen, welche dazu vorgesehen ist, den ersten Leitungspfadabschnitt und/oder den zusätzlichen ersten Leitungspfadabschnitt und/oder den zweiten Leitungspfadabschnitt und/oder den zusätzlichen zweiten Leitungspfadabschnitt zumindest teilweise, vorzugsweise vollständig, abzudecken.

Wenn der Blindstecker eine Gehäuseeinheit aufweist, welche dazu vorgesehen ist, zumindest die Ausgabeeinheit aufzunehmen, kann die Ausgabeeinheit vor äußeren Einflüssen, beispielsweise Staub und/oder Wasser, geschützt werden, sodass eine kompakte und sichere Konstruktion ermöglicht werden kann. Da die Gehäuseeinheit vorteilhaft einstückig aus einem Guss hergestellt ist kann eine Effizienz hinsichtlich eines Herstellungsprozesses des Blindsteckers maximal gesteigert und der Blindstecker kosteneffizient sowie leicht, insbesondere für Massenanfertigungen, hergestellt werden. Zudem kann eine Abmessung der Gehäuseeinheit an die Abmessungen von beliebigen Gegendatensteckereinheiten angepasst werden.

Vorzugsweise bildet die Gehäuseeinheit den Staubschutz für die Gegendatensteckereinheit und fungiert gleichzeitig als ein Halter für die Ausgabeeinheit. Die Gehäuseeinheit kann beispielsweise zumindest teilweise und/oder zu einem Großteil aus einem Mineral, insbesondere einem Glas, und/oder einem Metall und/oder vorzugsweise einem Kunststoff, insbesondere Thermoplast, und/oder einem Verbundmaterial bestehen. Es wäre denkbar, dass die Gehäuseeinheit zumindest ein zu der Datensteckereinheit, insbesondere der Ausgabeeinheit und/oder der Leiterplatte, identisches Material aufweist. Insbesondere ist die Gehäuseeinheit einstückig ausgebildet, welche beispielsweise durch einen Schweißprozess, einen Klebeprozess, einen Anspritzprozess und/oder einen anderen, dem Fachmann als sinnvoll erscheinenden Prozess geformt ist. Vorzugsweise ist die Gehäuseeinheit in einem Stück mittels eines Spritzgussverfahrens geformt. Beispielsweise könnte die Gehäuseeinheit aus einem Guss und/oder einem Ein- oder Mehrkomponentenspritzverfahren herstellbar sein.

Ferner wird vorgeschlagen, dass die Gehäuseeinheit mit der Leiterplatte verbunden ist. Dadurch kann eine vorteilhaft einfache und kostengünstige Konstruktion des Blindsteckers erreicht werden. Zudem kann auf eine zusätzliche Trägereinheit und/oder eine Isoliereinheit für die Leiterplatte verzichtet werden. Damit kann eine einfache und kostengünstige Montage der Leiterplatte auf der Gehäuseeinheit bereitgestellt werden.

Beispielsweise könnte die Leiterplatte mittels einer kraft- und/oder formschlüssigen Verbindung, wie beispielsweise einer Steckverbindung und/oder Drehverbindung und/oder Schraubverbindung, mit der Gehäuseeinheit verbunden sein. Alternativ könnte die Leiterplatte zu einer Fixierung mit der Gehäuseeinheit auch stoffschlüssig, und zwar geklebt und/oder angeschmolzen, sein. Vorzugsweise weist die Leiterplatte zumindest ein Pilotloch auf. Das Pilotloch könnte an zumindest einer von der Kante verschiedenen Seite der Leiterplatte angeordnet sein. Vorzugsweise könnte die Leiterplatte zwei Pilotlöcher aufweisen, welche an sich gegenüberliegenden Seiten der Leiterplatte positioniert sind. Das Pilotloch ist vorzugsweise dazu fähig, bei einer Montage der Leiterplatte auf der Gehäuseeinheit ein Einsetzen der Leiterplatte in die Gehäuseeinheit an eine für die Leiterplatte vorbestimmte Position zu führen. Das Pilotloch könnte in zumindest einem Verfahrensschritt bei der Herstellung der Leiterplatte gefräst und/oder ausgestanzt und/oder gebohrt und/oder gelasert und/oder vorzugsweise geritzt werden. In zumindest dem montierten Zustand ist die Leiterplatte mit der Gehäuseeinheit fixiert. Vorzugsweise könnte die Leiterplatte lediglich über die Pilotlöcher mit der Gehäuseeinheit verbunden und/oder fixiert sein. Insbesondere könnte die Gehäuseeinheit zumindest ein gewölbtes Führungselement aufweisen, welcher dazu vorgesehen ist, in dem montierten Zustand in das Pilotloch einzugreifen. Vorzugsweise ist das Führungselement an eine Form des Pilotlochs angepasst. Insbesondere könnte in zumindest einem weiteren Verfahrensschritt bei der Montage der Leiterplatte das Führungselement an das Pilotloch stoffschlüssig mittels eines Prästempels angeschmolzen werden. Es wäre denkbar, dass die Leiterplatte, insbesondere zumindest die von der Kante verschiedene Seite der Leiterplatte, in zumindest einem Verfahrensschritt bei der Herstellung der Leiterplatte mittels der Ritz-Methode herstellbar ist.

Zudem wird vorgeschlagen, dass die Gehäuseeinheit und die Leiterplatte gemeinsam einen zumindest im Wesentlichen abgeschlossenen Hohlraum bilden, in welchem die Ausgabeeinheit angeordnet ist. Damit kann ein maximaler Schutz der Ausgabeeinheit, insbesondere des Leuchtmittels und/oder des weiteren Leuchtmittels, vor äußeren Einflüssen, beispielsweise Staub, ermöglicht werden.

Die Gehäuseeinheit könnte zumindest eine Wandung, insbesondere zumindest eine Seitenwandung und/oder eine Bodenwandung und/oder eine Rückenwandung und/oder eine Vorderseitenwandung aufweisen. Insbesondere definiert die Rückenwandung eine der Gegendatensteckereinheit zugewandte Seite der Gehäuseeinheit. Die Vorderseitenwandung könnte eine der Gegendatensteckereinheit abgewandte Seite der Gehäuseeinheit definieren. Die Vorderseitenwandung und die Rückenwandung sind zumindest im Wesentlichen parallel zueinander angeordnet. Insbesondere sind zwischen der Vorderseitenwandung und der Rückenwandung zwei Seitenwandungen angeordnet, welche insbesondere jeweils rechtwinklig zu der Vorderseitenwandung und der Rückenwandung positioniert sind, wobei ein Winkel zwischen einer Längserstreckung der Vorderseitenwandung und/oder der Rückenwandung und einer Längserstreckung der Seitenwandungen in einem montierten Zustand insbesondere um höchstens 5°, vorzugsweise um maximal 2° und besonders vorteilhaft um höchstens 1° von einem rechten Winkel abweicht. Die Seitenwandungen, die Rückenwandung, die Bodenwandung und die Vorderseitenwandung könnten mit der Leiterplatte, insbesondere der Unterseite der Leiterplatte, den zumindest im Wesentlichen abgeschlosseneren Hohlraum bilden. Das vorzugsweise an der Unterseite der Leiterplatte angeordnete Leuchtmittel und/oder weitere Leuchtmittel könnte sich in dem zumindest im Wesentlichen abgeschlossenen Hohlraum befinden.

In einer weiten Ausgestaltung der Erfindung wird vorgeschlagen, dass die Gehäuseeinheit zumindest teilweise transparent, insbesondere transluzent, ausgebildet ist. Damit kann eine besonders effiziente Anzeige der Stromversorgungskapazität erreicht werden, da ein Leuchten des Leuchtmittels und/oder des weiteren Leuchtmittels durch die Gehäuseeinheit für einen Bediener erkennbar ist.

Insbesondere ist das Material der Gehäuseeinheit, insbesondere der Kunststoff, zumindest teilweise lichtdurchlässig, insbesondere transluzent und/oder transparent. Vorzugsweise ist die Gehäuseeinheit zumindest teilweise und/oder zu einem Großteil aus Polycarbonat (PC) und/oder Polyamid (PA) und/oder vorzugsweise aus Polymethylmethacrylat (PMMA) ausgebildet. Eine zumindest teilweise transparente Gehäuseeinheit könnte insbesondere zumindest im Wesentlichen durchsichtig sein und beispielsweise einen Streulichtanteil des Leuchtmittels und/oder des weiteren Leuchtmittels von insbesondere zumindest 3 %, vorteilhaft zumindest 10 %, und besonders vorteilhaft von höchstens 30 % aufweisen. Insbesondere könnte der Streulichtanteil bei einer zumindest teilweise transluzenten Gehäuseeinheit insbesondere zumindest 30 %, vorzugsweise zumindest 40 % und besonders bevorzugt zumindest 50 % betragen. Insbesondere tritt von dem Leuchtmittel und/oder dem weiteren Leuchtmittel emittiertes Licht diffus aus der zumindest teilweise transluzenten Gehäuseeinheit. Vorzugsweise transmittiert der Kunststoff der Gehäuseeinheit einen Lichtanteil von zumindest 60 %, vorzugsweise zumindest 80 % und besonders bevorzugt zumindest 90 % des Leuchtmittels und/oder des weiteren Leuchtmittels.

Ferner wird vorgeschlagen, dass die Gehäuseeinheit zumindest einen Lichtleiter aufweist, welcher einen Strahlengang zumindest einmal umlenkt. Hierdurch kann eine Effizienz weiter gesteigert und eine Konstruktion verbessert, insbesondere vereinfacht, werden. Zudem kann eine Ausgabe einer Stromversorgungskapazität einer Gegendatensteckereinheit erleichtert und damit wiederum ein Komfort gesteigert werden. Mittels eines Lichtleiters kann Licht, insbesondere bereitgestelltes Licht eines Leuchtmittels der Ausgabeeinheit, vorteilhaft gelenkt werden.

Der Lichtleiter könnte zumindest teilweise und/oder zu einem Großteil aus einem Mineral, beispielsweise Glas, und/oder einem Kunststoff und/oder einem Verbundmaterial bestehen. Bevorzugt ist der Lichtleiter aus einem zumindest teilweise durchsichtigen Kunststoffmaterial ausgebildet. Möglicherweise könnte der Lichtleiter eine gebogene oder eine gerade Form aufweisen. Der Lichtleiter könnte zumindest teilweise einteilig und vorzugsweise einstückig ausgebildet sein. Insbesondere bildet die Gehäuseeinheit den Lichtleiter aus. Der Lichtleiter könnte in dem Herstellungsprozess der Gehäuseeinheit einstückig, vorzugsweise einteilig, mit der Gehäuseeinheit ausgebildet werden. Unter "einstückig" soll zumindest stoffschlüssig verbunden verstanden werden, beispielsweise durch einen Klebeprozess, einen Anspritzprozess und/oder Schweißprozess und/oder einen anderen, einem Fachmann als sinnvoll erscheinenden Prozess. Ferner kann unter einstückig auch einteilig verstanden werden. Unter "einteilig" soll in einem Stück geformt verstanden werden. Vorzugsweise wird dieses eine Stück aus einem einzelnen Rohling, einer Masse und/oder einem Guss, besonders bevorzugt in einem Spritzgussverfahren, insbesondere einem Ein- und/oder Mehrkomponenten-Spritzgussverfahren, und/oder in einem Stanzverfahren aus dem einzelnen Rohling hergestellt.

Der Lichtleiter ist dazu vorgesehen, Licht, vorzugsweise bereitgestelltes Licht, von dem Leuchtmittel und/oder dem weiteren Leuchtmittel insbesondere direkt und vorteilhaft unbearbeitet, in Richtung zumindest einer Frontseite der Gehäuseeinheit zu führen. Vorteilhaft ist der Strahlengang ein Strahlengang des bereitgestellten Lichts ausgehend von dem Leuchtmittel und/oder dem weiteren Leuchtmittel. Insbesondere definiert der Lichtleiter einen Lichtaufnahmebereich. Der Lichtleiter könnte zumindest einen planen Eintrittsbereich für das Licht, insbesondere das bereitgestellte Licht des Leuchtmittels und/oder des weiteren Leuchtmittels, aufweisen, welcher vorteilhaft an eine Abmessung und/oder Form und/oder Größe des Leuchtmittels und/oder des weiteren Leuchtmittels angepasst ist. Das Leuchtmittel und/oder das weitere Leuchtmittel könnten zumindest im Wesentlichen senkrecht zu dem Eintrittsbereich des Lichtleiters ausgerichtet sein und Licht zumindest im Wesentlichen senkrecht auf den Eintrittsbereich einstrahlen. Unter "zumindest im Wesentlichen" soll in diesem Zusammenhang verstanden werden, dass eine Abweichung von einem vorgegebenen Wert weniger als 25 %, vorzugsweise weniger als 10 % und besonders bevorzugt weniger als 5 % des vorgegebenen Werts beträgt. Unter "zumindest im Wesentlichen senkrecht" soll in diesem Zusammenhang unter einem Winkel zwischen 85° und 95°, vorzugsweise zwischen 88° und 92° und besonders vorteilhaft von 90° verstanden werden.

Die Leiterplatte könnte senkrecht zu einer Steckrichtung an der Gehäuseeinheit angeordnet sein. Um eine Effizienz weiter zu steigern, und zwar hinsichtlich zumindest einer Herstellungs- und/oder Kosten- und/oder Montage- und/oder Demontageeffizienz wird vorgeschlagen, dass die Leiterplatte parallel zu einer Steckrichtung in die Gehäuseeinheit eingesteckt ist. Dadurch kann zudem ein Montage- und/oder Demontageaufwand reduziert werden.

Die Gehäuseeinheit könnte zumindest einen Führungssteg aufweisen. Vorteilhaft weist die Gehäuseeinheit einen Führungssteg und einen dem Führungssteg gegenüberliegenden weiteren Führungssteg auf. Die Leiterplatte könnte entlang des Führungsstegs und/oder des weiteren Führungsstegs in die Gehäuseeinheit einsetzbar und/oder eingesetzt sein. Insbesondere liegt die Leiterplatte auf dem Führungssteg und/oder dem weiteren Führungssteg auf. In zumindest dem Verfahrensschritt bei der Montage der Leiterplatte könnte die Leiterplatte parallel zu der Steckrichtung in die Gehäuseeinheit eingesteckt werden, und zwar insbesondere entlang des Führungsstegs und/oder des weiteren Führungsstegs in die Gehäuseeinheit einsetzbar und/oder einschiebbar sein.

Weist die Gehäuseeinheit zumindest ein Fixierelement auf, welches zu einer Fixierung der Datensteckereinheit, insbesondere der Leiterplatte, mit der Gegendatensteckereinheit vorgesehen ist, kann eine Effizienz und/oder eine Flexibilität, hinsichtlich einer Montage des Blindsteckers, insbesondere der Datensteckereinheit, vorteilhaft verbessert werden.

Beispielsweise könnte das Fixierelement an einer der Bodenwandung abgewandten Oberseite der Seitenwandung angeordnet sein. Insbesondere ist das Fixierelement mit der Gegendatensteckereinheit zugewandten Seite des Abdeckungselements, insbesondere einer der der Rückenwandung zugewandten Seite des Abdeckungselements, verbunden. Das Fixierelement ist dazu vorgesehen, in dem montierten Zustand eine Klemmwirkung, insbesondere eine Rastverbindung, der Datensteckereinheit mit der Gegendatensteckereinheit zu erzeugen und vorzugsweise die Datensteckereinheit in der Gegendatensteckereinheit zu fixieren, insbesondere zu verrasten. Das Fixierelement könnte zumindest teilweise deformierbar sein. Das Fixierelement kann beispielsweise als eine Rastnase und/oder als ein Rastnasenhebel und/oder als Clip ausgebildet sein. Das Fixierelement könnte in dem Herstellungsprozess der Gehäuseeinheit vorzugsweise einstückig mit der Gehäuseeinheit ausgebildet werden. Alternativ könnte das Fixierelement in dem weiteren Verfahrensschritt bei der Herstellung der Gehäuseeinheit aufgespritzt und/oder angeklebt und/der mit einem weiteren, dem Fachmann sinnvollen Prozess mit der Seitenwandung und dem Abdeckungselement verbunden werden.

Ferner wird vorgeschlagen, dass die Gehäuseeinheit zumindest ein Abdeckungselement aufweist, welches die Gegendatensteckereinheit flächenbündig abdeckt. Damit kann eine maximal gesteigerte Sicherheit der Gegendatensteckereinheit bereitgestellt werden, indem der Blindstecker als Staubschutz fungiert und die Gegendatensteckereinheit vor äußeren Einflüssen, beispielsweise Staub, schützt. Zudem kann zu einer besseren Funktionalität das Abdeckungselement eine Beschriftung aufweisen, um den Blindstecker mit der PoE Anzeigefunktion von herkömmlichen Blindsteckern unterscheiden zu können. Des Weiteren kann mittels einer Aussparung in dem Abdeckungselement der Blindstecker leicht von der Gegendatensteckereinheit entfernt werden.

Das Abdeckungselement könnte zumindest teilweise, vorzugsweise zu einem Großteil, und besonders bevorzugt vollständig die von der Gegendatensteckereinheit abgewandte Seite der Gehäuseeinheit, insbesondere die Vorderseitenwandung der Gehäuseeinheit, definieren. Vorzugsweise ist eine Oberseite des Abdeckungselements zumindest im Wesentlichen flächenbündig mit einer Oberfläche eines Umgebungsbereichs der Gegendatensteckereinheit, insbesondere einer dem Bildstecker zugewandten Seite der Gegendatensteckereinheit, angeordnet. Insbesondere entspricht ein Levelunterschied zwischen der Oberfläche des Abdeckungselements und der Oberfläche des Umgebungsbereichs der Gegendatensteckereinheit insbesondere maximal 5 %, vorzugsweise maximal 1 % und besonders bevorzugt maximal 0,5 % einer Dicke des Abdeckungselements. Das Abdeckungselement könnte auf einer der Gegendatensteckereinheit abgewandten Seite zumindest eine Beschriftung, beispielsweise ein Logo und/oder eine Signatur und/oder einen Hinweis, aufweisen. Das Abdeckungselement könnte zumindest an einer der Gegendatensteckereinheit zugewandten Kante eine Aussparung aufweisen, mittels welcher der Blindstecker, insbesondere die Gehäuseeinheit, von der Gegendatensteckereinheit entfernbar ist. Insbesondere könnte die Aussparung an zumindest zwei der Gegendatensteckereinheit zugewandten Kanten, insbesondere an zwei sich gegenüberliegenden Kanten des Abdeckungselements, angeordnet sein.

Darüber hinaus geht die Erfindung aus von einem Verfahren zur Anzeige einer Stromversorgungskapazität der Gegendatensteckereinheit, wobei ein Blindstecker mit der Gegendatensteckereinheit verbunden wird und mittels der Ausgabeeinheit die Stromversorgungskapazität angezeigt wird.

Es wird vorgeschlagen, dass die Ausgabeeinheit von einem Power Sourcing Equipment, insbesondere dem Power Sourcing Equipment (PSE), mittels eines Detektionssignals zur Detektion eines Power Devices, insbesondere dem Power Device (PD), versorgt wird. Dadurch kann eine Effizienz, hinsichtlich einer Ansteuerung der Ausgabeeinheit und/oder Anzeige der Stromversorgungskapazität der Gegendatensteckereinheit, insbesondere ein Betrieb des Blindsteckers, weiter optimiert werden.

Der Blindstecker soll hierbei nicht auf die oben beschriebene Anwendung und Ausführungsform beschränkt sein. Insbesondere kann der Blindstecker zu einer Erfüllung einer hierin beschriebenen Funktionsweise eine von einer hierin genannten Anzahl von einzelnen Elementen, Bauteilen und Einheiten abweichende Anzahl aufweisen.

### Zeichnungen

Weitere Vorteile ergeben sich aus der folgenden Zeichnungsbeschreibung. In den Zeichnungen sind zwei Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein als RJ45-System ausgebildetes Datenübertragungssystem mit einem Blindstecker und einer Gegendatensteckereinheit des Datenübertragungssystems,
- Fig. 2: eine Gehäuseeinheit des Blindsteckers,
- Fig. 3: die Gehäuseeinheit mit einer Leiterplatte des Blindsteckers,
- Fig. 4: eine Detailansicht einer Oberseite der Leiterplatte,
- Fig. 5: eine Detailansicht einer Unterseite der Leiterplatte,
- Fig. 6: ein Schema der Leiterplatte,
- Fig. 7: einen Blindstecker in einem weiteren Ausführungsbeispiel,
- Fig. 8: eine Gehäuseeinheit des Blindsteckers mit einer in die Gehäuseeinheit eingesteckten Leiterplatte des Blindsteckers gemäß Fig.7,
- Fig. 9: eine Rückansicht des Blindsteckers gemäß Figur 7 und
- Fig. 10: eine Schnittdarstellung des Blindsteckers gemäß Figur 7.

### Beschreibung der Ausführungsbeispiele

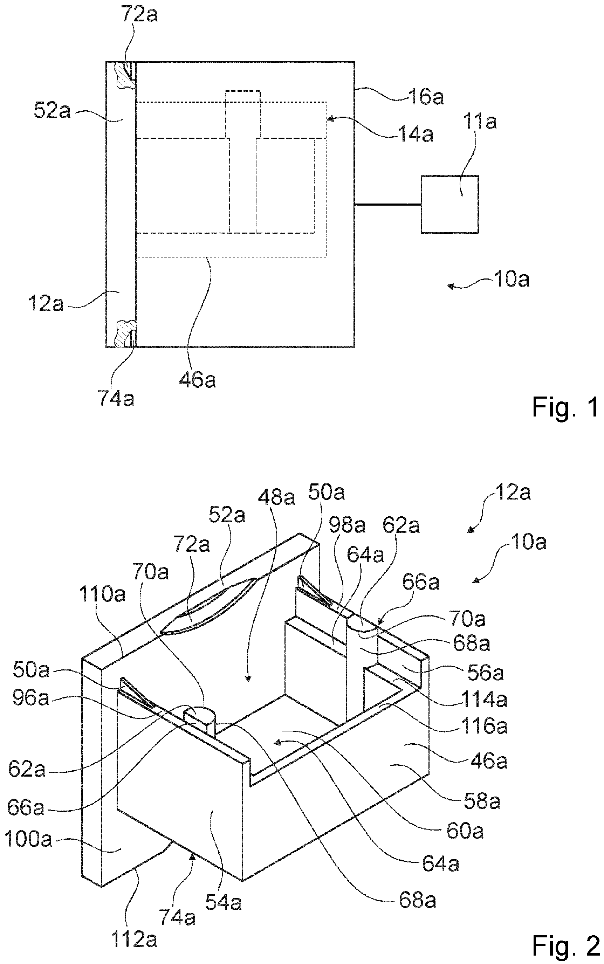

Fig. 1 zeigt ein als RJ45-System ausgebildetes Datenübertragungssystem 10a. In dieser beispielhaften Ausführungsform ist das Datenübertragungssystem 10a dazu befähigt, eine Power over Ethernet (PoE) Verbindung zu ermöglichen. Hierbei überträgt das Datenübertragungssystem 10a ein Datensignal des Datenübertragungssystems 10a zwischen einem Power Sourcing Equipment (PSE) 11a des Datenübertragungssystems 10a und einer Empfangseinheit des Datenübertragungssystems 10a und stellt eine Stromversorgung des Datenübertragungssystems 10a für die Empfangseinheit bereit.

Zu einer Übertragung des Datensignals und der Stromversorgung weist das Datenübertragungssystem 10a zumindest eine als RJ45-Steckerbuche ausgebildete Gegendatensteckereinheit 16a auf. Die als Blindstecker 12a ausgebildete Empfangseinheit weist zumindest eine Datensteckereinheit 14a auf. Entsprechend ist der Blindstecker 12a als RJ45-Blindstecker ausgebildet. In dieser beispielhaften Ausführungsform ist der Blindstecker 12a dazu vorgesehen, eine Stromversorgungskapazität der Gegendatensteckereinheit 16a zu überprüfen. Zudem ist der Blindstecker 12a dazu in der Lage, die Gegendatensteckereinheit 16a vor Staub zu schützen. In der Figur 1 ist ein montierter Zustand des Blindsteckers 12a gezeigt, in welchem der Blindstecker 12a in die Gegendatensteckereinheit 16a eingesteckt ist.

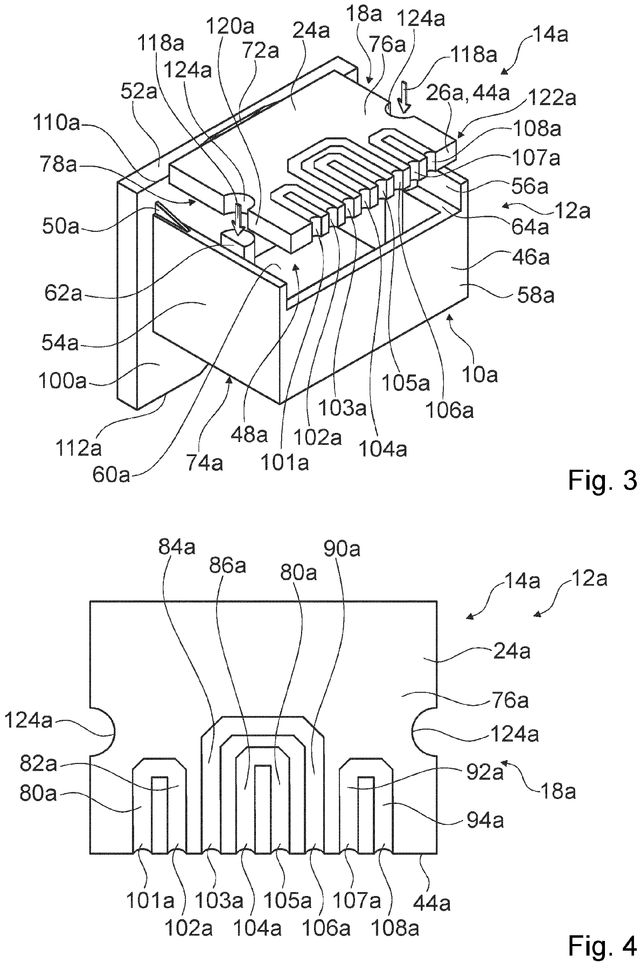

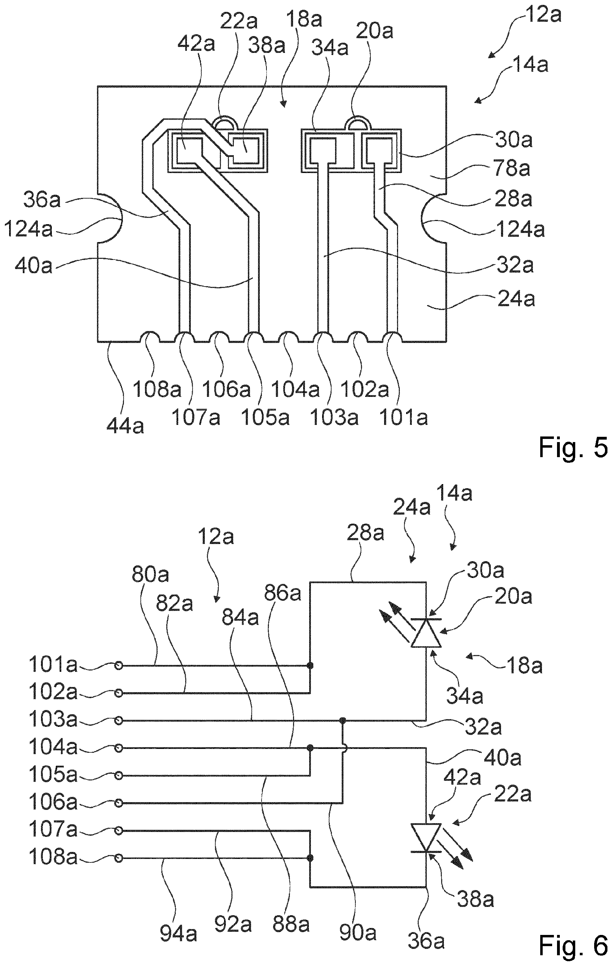

Die Figuren 2 und 3 zeigen jeweils einen detaillierten Aufbau des Blindsteckers 12a. Während in der Figur 2 explizit lediglich eine Gehäuseeinheit 46a des Blindsteckers 12a zu sehen ist, zeigt die Figur 3 die Gehäuseeinheit 46a und eine Leiterplatte 24a der Datensteckereinheit 14a. Zudem können den Figuren 4 und 5 Detailansichten der Leiterplatte 24a entnommen werden, wobei die Figur 6 ein Schema der Leiterplatte 24a zeigt.

Damit der Blindstecker 12a als Staubschutz fungiert, weist die Gehäuseeinheit 46a zumindest ein Abdeckungselement 52a auf. Wie der Figur 1 zu entnehmen ist, deckt das Abdeckungselement 52a die Gegendatensteckereinheit 16a flächenbündig ab. Das Abdeckungselement 52a definiert eine Vorderseitenwandung der Gehäuseeinheit 46a. Die Gehäuseeinheit 46a weist zudem zwei Seitenwandungen 54a, 56a auf, welche senkrecht an dem Abdeckungselement 52a angeordnet sind. Auf einer des Abdeckungselements 52a abgewandten Seite der Seitenwandungen 54a, 56a weist die Gehäuseeinheit 46a eine Rückenwandung 58a auf. Die Rückenwandung 58a begrenzt eine Tiefenrichtung der Gehäuseeinheit 46a ausgehend von dem Abdeckungselement 52a und ist ebenso senkrecht an den Seitenwandungen 54a, 56a angeordnet. Die Rückenwandung 58a und das Abdeckungselement 52a erstrecken sich zumindest im Wesentlichen parallel zueinander. Die Gehäuseeinheit 46a weist eine Bodenwandung 60a auf. Die Bodenwandung 60a ist senkrecht zu den Seitenwandungen 54a, 56a und jeweils senkrecht zu dem Abdeckungselement 52a und der Rückenwandung 58a angeordnet. Die Figuren 2 und 3 zeigen, dass das Abdeckungselement 52a mit den Seitenwandungen 54a, 56a, der Rückenwandung 58a und der Bodenwandung 60a einen Hohlraum 48a definieren. In dieser beispielhaften Ausführungsform ist die Gehäuseeinheit 46a einstückig ausgebildet und in einem Herstellungsprozess einstückig mittels eines Spritzgussverfahrens gefertigt.

Zu einer Fixierung der Datensteckereinheit 14a mit der Gegendatensteckereinheit 16a weist die Gehäuseeinheit 46a zumindest ein Fixierelement 50a auf. Das Fixierelement 50a ist an einer jeweiligen der Bodenwandung 60a abgewandten oberen Seite 96a, 98a der Seitenwandungen 54a, 56a angeordnet. Hierbei ist das Fixierelement 50a mit der Seite 96a, 98a und einer der Rückenwandung 58a zugewandten Seite 100a des Abdeckungselements 52a mit dem Abdeckungselement 52a verbunden. Das Fixierelement 50a ist dazu vorgesehen, in dem montierten Zustand eine Klemmwirkung der Datensteckereinheit 14a mit der Gegendatensteckereinheit 16a zu erzeugen.

Damit der Blindstecker 12a leicht aus der Gegendatensteckereinheit 16a zu entfernen ist, weist die Gehäuseeinheit 46a eine Aussparung 72a an einer der Gegendatensteckereinheit 16a zugewandten oberen Kante 110a des Abdeckungselements 52a auf. Korrespondierend zu der Aussparung 72a weist die Gehäuseeinheit 46a eine weitere Aussparung 74a an einer der Gegendatensteckereinheit 16a zugewandten unteren Kante 112a des Abdeckungselements 52a auf. Die obere Kante 110a und die untere Kante 112a befinden sich an der der Rückenwandung 58a zugewandten Seite 100a des Abdeckungselements 52a. Die Figur 1 zeigt jeweils einen Schnitt der oberen Kante 110a und der unteren Kante 112a mit der Aussparungen 72a und der weiteren Aussparung 74a.

Die Seitenwandungen 54a, 56a weisen jeweils an einer dem Hohlraum 48a zugewandten Seite eine Stufe 64a auf. In der Figur 2 ist deutlich zu erkennen, dass eine Erstreckungshöhe der Stufe 64a gleich einer Erstreckungshöhe der Rückenwandung 58a ist. Eine der Bodenwandung 60a abgewandte Seite 114a der Stufe 64a und eine der Bodenwandung 60a abgewandte Seite 116a der Rückenwandung 58a liegen folglich in einer Ebene, wobei sie senkrecht zueinander angeordnet sind.

An der dem Hohlraum 48a zugewandten Seite ist an den Seitenwandungen 54a, 56a jeweils ein Führungselement 62a der Gehäuseeinheit 46a angeordnet. Das Führungselement 62a ist an einer der Seitenwandung 54a, 56a zugewandten Seite 66a stoffschlüssig mit der Seitenwandung 54a, 56a verbunden. Auf einer dem Hohlraum 48a zugewandten Seite 68a des Führungselements 62a definiert das Führungselement 62a eine halbkreisförmige in den Hohlraum 48a hineinragende Wölbung 70a. Das Führungselement 62a erstreckt sich über eine Erstreckungshöhe der der Bodenwandung 60a abgewandten Seite 96a, 98a der Seitenwandung 54a, 56a und ragt über diese Seiten 96a, 98a hinaus.

Das Führungselement 62a ist bei dem Einsetzen der Leiterplatte 24a zu einer korrekten Positionierung mit der Gehäuseeinheit 46a vorgesehen. Hierzu weist die Leiterplatte 24a jeweils an einer den Seitenwandungen 54a, 56a zugewandten Seite 120a, 122a ein Pilotloch 124a auf. Das Führungselement 62a ist an eine Form des Pilotlochs 124a angepasst. In dem montierten Zustand sind die Gehäuseeinheit 46a und die Leiterplatte 24a über das Pilotloch 124a und das Führungselement 62a miteinander verbunden. Das Pilotloch 124a ist dazu vorgesehen, mit dem Führungselement 62a die Leiterplatte 24a an der Gehäuseeinheit 46a zu fixieren.

Zu einer Anzeige einer Stromversorgungskapazität der Gegendatensteckereinheit 16a weist die Datensteckereinheit 14a zumindest eine Ausgabeeinheit 18a auf. Die Ausgabeeinheit 18a ist zu einer elektrischen Versorgung mit der Leiterplatte 24a verbunden. Der Figur 3 ist zu entnehmen, dass in einem Verfahrensschritt bei einer Herstellung des Blindsteckers 12a, die Leiterplatte 24a mit einer Unterseite 78a der Leiterplatte 24a entlang einer Montagerichtung 118a in die Gehäuseeinheit 46a eingesetzt wird. Damit bilden die Gehäuseeinheit 46a und die Unterseite 78a der Leiterplatte 24a gemeinsam den zumindest im Wesentlichen abgeschlossenen Hohlraum 48a. Die Gehäuseeinheit 46a ist dazu vorgesehen, die Ausgabeeinheit 18a aufzunehmen. Die Ausgabeeinheit 18a ist an der Unterseite 78a der Leiterplatte 24a angeordnet. Ist die Leiterplatte 24a mit der Gehäuseeinheit 46a fixiert, ist die Ausgabeeinheit 18a in dem Hohlraum 48a positioniert. Wie den Figuren 5 und 6 entnommen werden kann, weist die Ausgabeeinheit 18a zumindest ein als LED 20a ausgebildetes Leuchtmittel auf. Zudem weist die Ausgabeeinheit 18a zumindest eine weitere LED 22a als weiteres Leuchtmittel auf. Die LED 20a und die weitere LED 22a sind auf der Unterseite 78a der Leiterplatte 24a angeordnet. Damit befinden sich die LED 20a und die weitere LED 22a in dem montierten Zustand in zumindest dem Hohlraum 48a. Zu einer Anzeige der Stromversorgungskapazität der Gegendatensteckereinheit 16a mittels der LED 20a und der weiteren LED 22a ist die Gehäuseeinheit 46a zumindest teilweise transparent ausgebildet.

Im Folgenden soll die Ausgestaltung der Leiterplatte 24a anhand der Figuren 3, 4 und 5 sowie das Schema der Leiterplatte 24a in Figur 6 detaillierter beschrieben werden. Während die Figuren 3 und 4 eine Oberseite 76a der Leiterplatte 24a zeigen, kann der Figur 5 eine Ausgestaltung der Unterseite 78a der Leiterplatte 24a entnommen werden.

Zu einer Kontaktierung mit Gegenkontakten (nicht dargestellt) der Gegendatensteckereinheit 16a weist die Leiterplatte 24a Kontakte 101a, 102a, 103a, 104a, 105a, 106a, 107a, 108a auf. Die Kontakte 101a, 102a, 103a, 104a, 105a, 106a, 107a, 108a sind in Einbuchtungen an einer der Gegendatensteckereinheit 16a zugewandten Seite 26a angeordnet.

Die Leiterplatte 24a weist zumindest einen ersten Leitungspfad 28a auf, welcher zumindest einen ersten der Kontakte 101a, 102a mit einem ersten Anschluss 30a der LED 20a elektrisch leitend verbindet. Zudem weist die Leiterplatte 24a einen zweiten Leitungspfad 32a auf, welcher zumindest einen zweiten der Kontakte 103a, 106a mit einem zweiten Anschluss 34a der LED 20a elektrisch leitend verbindet. Mittels des ersten Leitungspfads 28a und mittels des zweiten Leitungspfads 32a ist die LED 20a mit zumindest zwei der Kontakte 101a, 102a, 103a, 106a elektrisch leitend verbunden (vgl. Figur 5).

Die Leiterplatte 24a weist zumindest einen weiteren ersten Leitungspfad 36a auf, welcher zumindest einen weiteren ersten der Kontakte 107a, 108a mit einem weiteren ersten Anschluss 38a der weiteren LED 22a elektrisch leitend verbindet. Zudem weist die Leiterplatte 24a einen weiteren zweiten Leitungspfad 40a auf, welcher zumindest einen weiteren zweiten der Kontakte 104a, 105a mit einem weiteren zweiten Anschluss 42a der weiteren LED 22a elektrisch leitend verbindet. Damit ist die weitere LED 22a über den weiteren ersten Leitungspfad 36a und den weiteren zweiten Leitungspfad 40a mit zumindest weiteren zwei der weiteren Kontakte 104a, 105a, 107a, 108a elektrisch leitend verbunden (vgl. Figur 5).

In dieser beispielhaften Ausführung zeigt die Figur 5, dass der erste Anschluss 30a, der zweite Anschluss 34a, der weitere erste Anschluss 38a und der weitere zweite Anschluss 42a auf der Unterseite 78a der Leiterplatte 24a angeordnet sind.

Das in Figur 6 dargestellte Schema der Leiterplatte 24a zeigt, dass der erste Leitungspfad 28a einen ersten Leitungspfadabschnitt 80a und einen zusätzlichen ersten Leitungspfadabschnitt 82a aufweist. Der erste Leitungspfadabschnitt 80a ist mit dem ersten Kontakt 101a und der zusätzliche erste Leitungspfadabschnitt 82a mit dem einem zusätzlichen ersten Kontakt 102a verbunden. Hierbei sind der erste Kontakt 101a und der zusätzliche erste Kontakt 102a benachbart. Der zweite Leitungspfad 32a weist ebenfalls einen zweiten Leitungspfadabschnitt 84a und einen zusätzlichen zweiten Leitungspfadabschnitt 90a auf. Der zweite Leitungspfadabschnitt 84a ist mit dem zweiten Kontakt 103a und der zusätzliche zweite Leitungspfadabschnitt 90a mit dem einem zusätzlichen zweiten Kontakt 106a verbunden. Die Figuren 4 und 6 zeigen, dass der erste Leitungspfadabschnitt 80a mit dem zusätzlichen ersten Leitungspfadabschnitt 82a auf der Oberseite 76a der Leiterplatte 24a kurzgeschlossen ist. Auch der zweite Leitungspfadabschnitt 84a ist mit dem zusätzlichen zweiten Leitungspfadabschnitt 90a auf der Oberseite 76a der Leiterplatte 24a kurzgeschlossen.

Des Weiteren zeigt das in Figur 6 dargestellte Schema der Leiterplatte 24a, dass der weitere erste Leitungspfad 36a einen weiteren ersten Leitungspfadabschnitt 92a und einen weiteren zusätzlichen ersten Leitungspfadabschnitt 94a aufweist. Der weitere erste Leitungspfadabschnitt 92a ist mit dem weiteren ersten Kontakt 107a und der weitere zusätzliche erste Leitungspfadabschnitt 94a mit dem einem weiteren zusätzlichen ersten Kontakt 108a verbunden. Hierbei sind der weitere erste Kontakt 107a und der weitere zusätzliche erste Kontakt 108a benachbart. Der weitere zweite Leitungspfad 40a weist ebenfalls einen weiteren zweiten Leitungspfadabschnitt 86a und einen weiteren zusätzlichen zweiten Leitungspfadabschnitt 88a auf. Der weitere zweite Leitungspfadabschnitt 86a ist mit dem weiteren zweiten Kontakt 104a und der weitere zusätzliche zweite Leitungspfadabschnitt 88a mit dem einem weiteren zusätzlichen zweiten Kontakt 105a verbunden. Hierbei sind der weitere zweite Kontakt 104a und der weitere zusätzliche zweite Kontakt 105a benachbart angeordnet. Die Figuren 4 und 6 zeigen, dass der weitere erste Leitungspfadabschnitt 92a mit dem weiteren zusätzlichen ersten Leitungspfadabschnitt 94a auf der Oberseite 76a der Leiterplatte 24a kurzgeschlossen ist. Zudem ist den Figuren 4 und 6 zu entnehmen, dass der weitere zweite Leitungspfadabschnitt 86a mit dem weiteren zusätzlichen zweiten Leitungspfadabschnitt 88a auf der Oberseite 76a der Leiterplatte 24a kurzgeschlossen ist.

Zu einer elektrischen Verbindung zwischen der Oberseite 76a der Leiterplatte 24a und der Unterseite 78a der Leiterplatte 24a verläuft der erste Leitungspfad 28a und der zweite Leitungspfad 32a und der weitere erste Leitungspfad 36a und der weitere zweite Leitungspfad 40a über eine Kante 44a der Leiterplatte 24a. Die Kante 44a befindet sich an der der Gegendatensteckereinheit 16a zugewandten Seite 26a der Leiterplatte 24a.

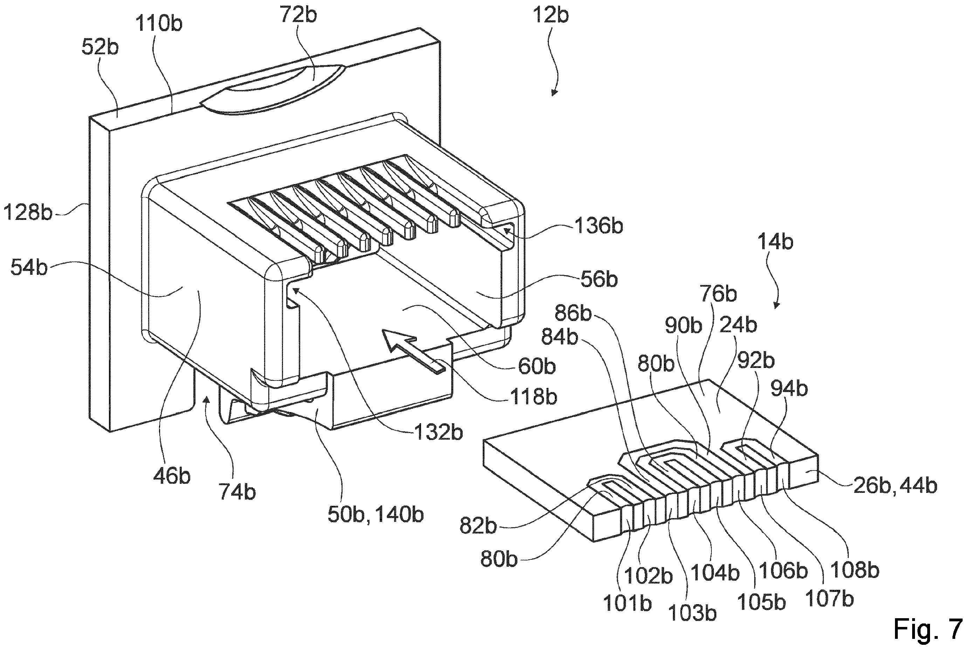

In Figuren 7 bis 10 ist ein weiteres Ausführungsbeispiel der Erfindung gezeigt. Die nachfolgenden Beschreibungen beschränken sich im Wesentlichen auf die Unterschiede zwischen den Ausführungsbeispielen, wobei bezüglich gleichbleibender Bauteile, Merkmale und Funktionen auf die Beschreibung des Ausführungsbeispiels der Figuren 1 bis 6 verwiesen werden kann. Zur Unterscheidung der Ausführungsbeispiele ist der Buchstabe a in den Bezugszeichen des Ausführungsbeispiels in den Figuren 1 bis 6 durch den Buchstaben b in den Bezugszeichen des Ausführungsbeispiels in den Figuren 7 bis 10 ersetzt.

Bezüglich gleich bezeichneter Bauteile, insbesondere in Bezug auf Bauteile mit gleichen Bezugszeichen, kann grundsätzlich auch auf die Zeichnungen und/oder die Beschreibung des Ausführungsbeispiels der Figuren 1 bis 6 verwiesen werden.

Die Figur 7 zeigt einen Blindstecker 12b eines weiteren Ausführungsbeispiels. Der Blindstecker 12b weist eine Datensteckereinheit 14b mit zumindest einer Leiterplatte 24b auf. Der Blindstecker 12b weist eine Gehäuseeinheit 46b auf. Die Leiterplatte 24b ist mit der Gehäuseeinheit 46b verbunden. Der Blindstecker 12b des vorliegenden Ausführungsbeispiels unterscheidet sich zu dem Blindstecker 12a des Ausführungsbeispiels a zumindest in einer Anordnung und/oder Verbindung der Leiterplatte 24b mit und/oder an der Gehäuseeinheit 46b. Vorliegend ist die Leiterplatte 24b parallel zu einer Steckrichtung in die Gehäuseeinheit 46b eingesteckt. Figur 7 verdeutlicht eine Montagerichtung 118b, welche parallel zu der Steckrichtung verläuft. Die Leiterplatte 24b ist entlang der Montagerichtung 118b in die Gehäuseeinheit 46b eingesetzt.

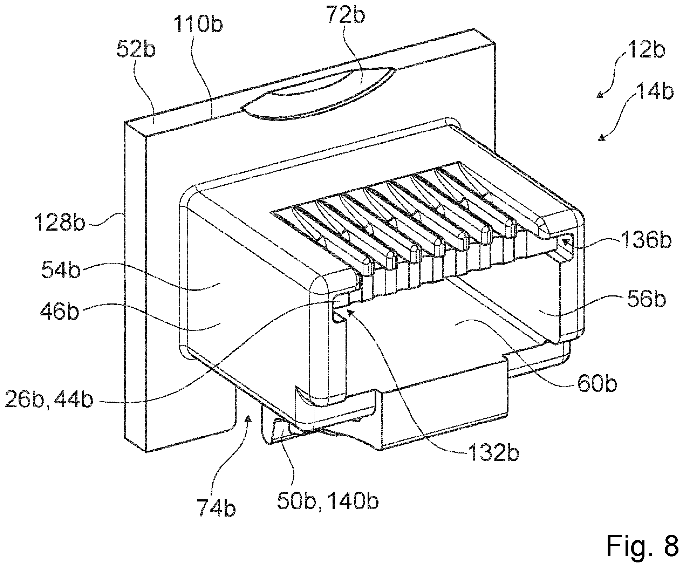

In dieser beispielhaften Ausführung weist die Gehäuseeinheit 46b zumindest einen Führungssteg 132b auf. Ferner weist die Gehäuseeinheit 46b einen weiteren dem Führungssteg 132b gegenüberliegend angeordneten weiteren Führungssteg 136b auf. Die Leiterplatte 24b ist entlang des Führungsstegs 132b und des weiteren Führungsstegs 136b in die Gehäuseeinheit 46b eingesetzt (vgl. Figuren 8 bis 10). Die Leiterplatte 24b liegt in einem montierten Zustand auf dem Führungssteg 132b und dem weiteren Führungssteg 136b auf. Den Figuren 7 bis 10 ist zu entnehmen, dass ein Bereich unterhalb der Leiterplatte 24b und innerhalb der Gehäuseeinheit 46b vorliegend leer ist. Alternativ könnte dieser Bereich auch mit zumindest einem Material und/oder einer Materialzusammensetzung, wie beispielsweise Kunststoff und/oder Harz und/oder einem Verbundmaterial, zumindest teilweise ausgefüllt sein.

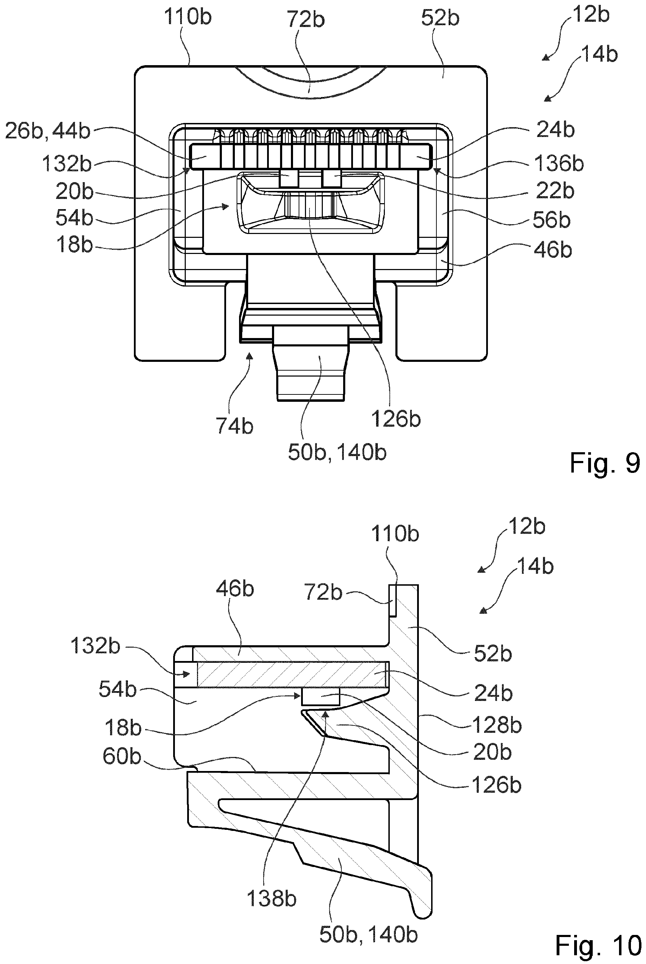

Vorliegend weist die Gehäuseeinheit 46b zumindest einen Lichtleiter 126b auf, welcher einen Strahlengang zumindest einmal umlenkt (vgl. Figuren 9 und 10). In dieser beispielhaften Ausführung bildet die Gehäuseeinheit 46b den Lichtleiter 126b aus. Die Datensteckereinheit 14b umfasst eine Ausgabeeinheit 18b, welche zumindest ein Leuchtmittel 20b aufweist. Die Ausgabeeinheit 18b weist zumindest ein weiteres Leuchtmittel 22b auf. Vorliegend ist die Leiterplatte 24b derart in der Gehäuseeinheit 46b angeordnet, dass zumindest das Leuchtmittel 20b und/oder das weitere Leuchtmittel 22b zumindest im Wesentlichen senkrecht zu einem Eintrittsbereich 138b des Lichtleiters 126b ausgerichtet ist/sind (vgl. Figur 10). Der Eintrittsbereich 138b des Lichtleiters 126b ist vorliegend an eine Abmessung und/oder Form und/oder Größe des Leuchtmittels 20b und/oder des weiteren Leuchtmittels 22b angepasst. Der Lichtleiter 126b ist dazu vorgesehen, von dem Leuchtmittel 20b und/oder dem weiteren Leuchtmittel 22b bereitgestelltes Licht direkt und vorliegend unbearbeitet in Richtung zumindest einer Frontseite 128b der Gehäuseeinheit 46b zu führen (vgl. Figur 10).

Ferner unterscheidet sich der Blindstecker 12b des vorliegenden Ausführungsbeispiels zu dem Blindstecker 12a des Ausführungsbeispiels a durch eine anderweitige Ausgestaltung eines Fixierelements 50b der Gehäuseeinheit 46b. Vorliegend ist das Fixierelement 50b als ein Rastnasenhebel 140b ausgebildet (vgl. Figuren 7 bis 10). Das Fixierelement 50b ist dazu vorgesehen, in dem montierten Zustand eine Klemmwirkung und/oder Rastverbindung der Datensteckereinheit 14b mit einer Gegendatensteckereinheit zu erzeugen (nicht dargestellt).

### Bezugszeichen

- 10: Datenübertragungssystem
- 11: Power Sourcing Equipment (PSE)
- 12: Blindstecker
- 14: Datensteckereinheit
- 16: Gegendatensteckereinheit
- 18: Ausgabeeinheit
- 20: Leuchtmittel
- 22: Weitere Leuchtmittel
- 24: Leiterplatte
- 26: Seite
- 28: Erster Leitungspfad
- 30: Erster Anschluss
- 32: Zweiter Leitungspfad
- 34: Zweiter Anschluss
- 36: Weiterer erster Leitungspfad
- 38: Weiterer erster Anschluss
- 40: Weiterer zweiter Leitungspfad
- 42: Weiterer zweiter Anschluss
- 44: Kante
- 46: Gehäuseeinheit
- 48: Hohlraum
- 50: Fixierelement
- 52: Abdeckungselement
- 54: Seitenwandung
- 56: Seitenwandung
- 58: Rückenwandung
- 60: Bodenwandung
- 62: Führungselement
- 64: Stufe
- 66: Seite
- 68: Seite
- 70: Wölbung
- 72: Aussparung
- 74: Weitere Aussparung
- 76: Oberseite Leiterplatte
- 78: Unterseite Leiterplatte
- 80: Leitungspfadabschnitt
- 82: Leitungspfadabschnitt
- 84: Leitungspfadabschnitt
- 86: Leitungspfadabschnitt
- 88: Leitungspfadabschnitt
- 90: Leitungspfadabschnitt
- 92: Leitungspfadabschnitt
- 94: Leitungspfadabschnitt
- 96: Seite
- 98: Seite
- 100: Seite
- 101: Kontakt
- 102: Kontakt
- 103: Kontakt
- 104: Kontakt
- 105: Kontakt
- 106: Kontakt
- 107: Kontakt
- 108: Kontakt
- 110: Obere Kante
- 112: Untere Kante
- 114: Seite
- 116: Seite
- 118: Montagerichtung
- 120: Seite
- 122: Seite
- 124: Pilotloch
- 126: Lichtleiter
- 128: Frontseite
- 132: Führungssteg
- 136: Führungssteg
- 138: Eintrittsbereich
- 140: Rastnasenhebel

## Patentansprüche

1. Blindstecker (12a-b), insbesondere RJ45-Blindstecker, mit zumindest einer Datensteckereinheit (14a-b), welche zu einer Verbindung mit einer Gegendatensteckereinheit (16a), insbesondere einer RJ45-Steckerbuchse, vorgesehen ist, **dadurch gekennzeichnet, dass** die Datensteckereinheit (14a-b) eine Ausgabeeinheit (18a-b) aufweist, welche dazu vorgesehen ist, eine Stromversorgungskapazität der Gegendatensteckereinheit (16a) anzuzeigen.

2. Blindstecker (12a-b) nach Anspruch 1, **dadurch gekennzeichnet, dass** in zumindest einem Betriebszustand zumindest eine elektrische Kenngröße der Ausgabeeinheit (18a-b) unterhalb oder oberhalb eines Grenzwerts der elektrischen Kenngröße für eine Detektion als Power Device liegt.

3. Blindstecker (12a-b) nach Anspruch 1 oder 2, **dadurch gekennzeichnet, dass** die Ausgabeeinheit (18a-b) zumindest ein Leuchtmittel (20a-b), insbesondere eine LED, aufweist.

4. Blindstecker (12a-b) nach Anspruch 3, **dadurch gekennzeichnet, dass** die Datensteckereinheit (14a-b) zumindest eine Leiterplatte (24a-b) aufweist, welche Kontakte (101a-b, 102a-b, 103a-b, 104a-b, 105a-b, 106a-b, 107a-b, 108a-b) zur Kontaktierung mit Gegenkontakten der Gegendatensteckereinheit (16a) aufweist.

5. Blindstecker (12a-b) nach den Ansprüchen 3 und 4, **dadurch gekennzeichnet, dass** die Leiterplatte (24a-b) zumindest einen ersten Leitungspfad (28a), welcher einen ersten der Kontakte (101a-b, 102a-b, 103a-b, 104a-b, 105a-b, 106a-b, 107a-b, 108a-b) mit einem ersten Anschluss (30a) des Leuchtmittels (20a-b) elektrisch leitend verbindet, und zumindest einen zweiten Leitungspfad (32a), welcher einen zweiten der Kontakte (101a-b, 102a-b, 103a-b, 104a-b, 105a-b, 106a-b, 107a-b, 108a-b) mit einem zweiten Anschluss (34a) des Leuchtmittels (20a-b) elektrisch leitend verbindet, aufweist, über welche das Leuchtmittel (20ab) mit zumindest zwei der Kontakte (101a-b, 102a-b, 103a-b, 104a-b, 105a-b, 106a-b, 107a-b, 108a-b) elektrisch leitend verbunden ist.

6. Blindstecker (12a-b) nach Anspruch 5, **dadurch gekennzeichnet, dass** die Ausgabeeinheit (18a-b) ein weiteres Leuchtmittel (22a-b), insbesondere eine weitere LED, und die Leiterplatte (24a-b) zumindest einen weiteren ersten Leitungspfad (36a), welcher einen weiteren ersten der Kontakte (101a-b, 102a-b, 103a-b, 104a-b, 105a-b, 106a-b, 107a-b, 108a-b) mit einem weiteren ersten Anschluss (38a) des weiteren Leuchtmittels (22a-b) elektrisch leitend verbindet, und zumindest einen weiteren zweiten Leitungspfad (40a), welcher einen weiteren zweiten der Kontakte (101a-b, 102a-b, 103a-b, 104a-b, 105a-b, 106a-b, 107a-b, 108a-b) mit einem weiteren zweiten Anschluss (42a) des weiteren Leuchtmittels (22a-b) elektrisch leitend verbindet, aufweist, über welche das weitere Leuchtmittel (22ab) mit zumindest weiteren zwei der weiteren Kontakte (101a-b, 102a-b, 103a-b, 104a-b, 105a-b, 106a-b, 107a-b, 108a-b) elektrisch leitend verbunden ist.

7. Blindstecker (12a-b) nach Anspruch 5 oder 6, **dadurch gekennzeichnet, dass** der erste und/oder der zweite Leitungspfad (28a, 32a, 36a, 40a) über eine Kante (44a-b) der Leiterplatte (24a-b) verläuft.

8. Blindstecker (12a-b) nach einem der vorhergehenden Ansprüche, **gekennzeichnet durch** eine Gehäuseeinheit (46a-b), welche dazu vorgesehen ist, zumindest die Ausgabeeinheit (18a-b) aufzunehmen.

9. Blindstecker (12a-b) zumindest nach den Ansprüchen 4 und 8, **dadurch gekennzeichnet, dass** die Gehäuseeinheit (46a-b) mit der Leiterplatte (24a-b) verbunden ist.

10. Blindstecker (12a) nach Anspruch 9, **dadurch gekennzeichnet, dass** die Gehäuseeinheit (46a) und die Leiterplatte (24a) gemeinsam einen zumindest im Wesentlichen abgeschlossenen Hohlraum (48a) bilden, in welchem die Ausgabeeinheit (18a) angeordnet ist.

11. Blindstecker (12a-b) nach einem der Ansprüche 8 bis 10, **dadurch gekennzeichnet, dass** die Gehäuseeinheit (46a-b) zumindest teilweise transparent ausgebildet ist.

12. Blindstecker (12b) nach einem der Ansprüche 8 bis 11, **dadurch gekennzeichnet, dass** die Gehäuseeinheit (46b) zumindest einen Lichtleiter (126b) aufweist, welcher einen Strahlengang zumindest einmal umlenkt.

13. Blindstecker (12b) nach einem der Ansprüche 8 bis 12, **dadurch gekennzeichnet, dass** die Leiterplatte (24b) parallel zu einer Steckrichtung in die Gehäuseeinheit (46b) eingesteckt ist.

14. Blindstecker (12a-b) nach einem der vorhergehenden Ansprüche, **dadurch gekennzeichnet, dass** die Gehäuseeinheit (46a-b) zumindest ein Fixierelement (50a-b) aufweist, welches zu einer Fixierung der Datensteckereinheit (14a-b) mit der Gegendatensteckereinheit (16a) vorgesehen ist.

15. Blindstecker (12a-b) nach einem der vorhergehenden Ansprüche, **dadurch gekennzeichnet, dass** die Gehäuseeinheit (46a-b) zumindest ein Abdeckungselement (52a-b) aufweist, welches die Gegendatensteckereinheit (16a) flächenbündig abdeckt.

16. Datenübertragungssystem (10a), insbesondere RJ45-System, mit einem Blindstecker (12a-b) nach einem der vorhergehenden Ansprüche und mit der Gegendatensteckereinheit (16a), mit welcher der Blindstecker (12a-b) verbunden ist.

17. Verfahren zur Anzeige einer Stromversorgungskapazität der Gegendatensteckereinheit (16a), wobei ein Blindstecker (12a-b) nach einem der Ansprüche 1 bis 15 mit der Gegendatensteckereinheit (16a) verbunden wird und mittels der Ausgabeeinheit (18a-b) die Stromversorgungskapazität angezeigt wird.

18. Verfahren nach Anspruch 17, **dadurch gekennzeichnet, dass** die Ausgabeeinheit (18a-b) von einem Power Sourcing Equipment (11a) mittels eines Detektionssignals zur Detektion eines Power Devices versorgt wird.
